# EUROPEAN PATENT APPLICATION

(11) **EP 2 058 827 A1**
(43) Date of publication of application: **13.05.2009**
(21) Application number: 08168777.4
(22) Date of filing: 10.11.2008
(51) Int. Cl.: H01F 27/40

(54) **A switched mode power supply transformer**

(30) Priority: 09.11.2007 IE 20070817
(71) Applicant: Vox Power Limited, Dublin 6W (IE)
(72) Inventor: Prinsloo, Marco Karl, 6W, Dublin (IE); McDonald, Brian, 14, Dublin (IE)
(74) Representative: McCrann, Sarah Ann

(57) **Abstract**

A switched mode power supply transformer for use in a modular switched mode power supply, the transformer comprising a primary winding (106), a magnetic core (108) and at least one configurable secondary winding (110,111) so as to provide a switched mode power supply transformer that is small in size, low in weight, is user configurable and has low power losses.

## Description

### INTRODUCTION

The present invention relates to a switched mode power supply transformer for use in a modular switched mode power supply, the transformer comprising a primary winding, a magnetic core and at least one secondary winding. Such a transformer may be used in switched mode power supplies providing isolated outputs. Such power supplies are widely used in a variety of electronic devices.

Transformers are widely known electro-magnetic components used in electrical devices and power supply units, to provide energy transfer between isolated circuits. The conventional switched mode power supply transformer comprises an insulator gap between a primary coil and a secondary coil around a ferromagnetic core. To prevent saturation of the ferromagnetic core material, transformers are driven by an alternating voltage source connected to the primary coil. The voltage generated in the secondary coil is determined by the voltage applied to the primary coil multiplied by the winding ratio between the primary coil and the secondary coil. Multiple secondary coils can be used to generate multiple outputs from a single primary coil within the same transformer core, and different primary to secondary winding ratios can be used to generate different output voltages on each secondary coil. A power supply is typically required to generate multiple output voltages to power different devices within an end system. These outputs are typically required to be isolated from both the primary circuit and each other. When used in a direct current (DC) power supply, the alternating (AC) voltage produced by the secondary coil will be fed through a rectification circuit to produce a direct current (DC) voltage at the output.

Currently, there are two types of transformer arrangements used to provide the features necessary for use in switched mode power supplies, such as multiple isolated outputs. The first arrangement consists of a single magnetic core containing a single primary winding with a fixed number of turns and multiple secondary windings with varying numbers of turns to generate the required voltages and currents for the end system. This arrangement has the advantage of using only a single magnetic core to generate multiple isolated outputs, which minimises the size, weight and losses associated with the transformer. Although this system can be implemented in a modular fashion, the transformer must be constructed at the factory with the correct turns ratio on each secondary winding to produce the output voltages required for each end system. Once constructed, the primary to secondary turns ratios and hence the output voltages cannot be changed without disassembling the transformer structure and replacing the individual windings. Hence, power supplies using these transformers are not user configurable.

User configurability is a desirable property in modular power supplies for many reasons. The manufacturer can build and distribute standard modules without having to configure each power supply for the end customer's requirements. This greatly improves manufacturing efficiency and flexibility. Also the end customer can buy or hold stock of these standard modules from local sources and configure a power supply to meet their requirements much more quickly than if they have to contact the manufacturer to configure the power supply for them.

The second transformer arrangement currently in use specifically addresses the user configurability issue. It uses multiple transformers within a single power supply unit to generate the required voltages and currents for the end system. All the transformers may be driven in parallel by a single driver stage but produce different output voltages due to their individual turns ratios. Using this arrangement, individual replaceable modules with different output voltage and current ratings can be constructed that contain a complete transformer and associated circuitry for each output. These modules can then be combined within an appropriate power supply unit to suit each end application, and hence allow the unit to be configured by unskilled persons at any location.

Disadvantageously, each transformer in this arrangement will have a similar size, weight and power losses as that of the previous single transformer arrangement, and the overall size, weight and power losses of the power supply will increase substantially as the number of outputs increases.

It is an object therefore of the present invention to provide a switched mode power supply transformer for use in a modular switched mode power supply that overcomes the problems associated with the currently available solutions, namely a switched mode power supply transformer for use in isolated multiple output power supplies that is small in size, low in weight, is user configurable and has low power losses.

### STATEMENTS OF INVENTION

According to the invention there is provided a switched mode power supply transformer for use in a modular switched mode power supply, the transformer comprising a primary winding, a magnetic core and at least one secondary winding characterised in that the at least one secondary winding comprises at least one of a plurality of discrete sub-winding sections, each sub-winding section being connectable to another sub-winding section in the at least one secondary winding in a series or parallel manner.

In this way, the a transformer is provided wherein it maintains the advantages of a single core transformer, but also has the advantage of user-configurability as the user may configure each secondary winding to meet his requirements simply by connecting the sub-winding sections together in the appropriate arrangements. Connecting the sub-winding sections in parallel increases the current rating of the secondary winding, while connecting the sub-winding sections in series increases the number of turns in the secondary winding.

In one embodiment of the invention there is provided a transformer in which the transformer comprises a transformer module, a linking module and at least one transformer output, wherein the transformer module comprises a transformer module connector apparatus and the plurality of discrete sub-winding sections, each of which is connected to the transformer module connector apparatus; and the linking module comprises a linking module connector apparatus suitable for engagement with the transformer module connector apparatus; a connection between the transformer output and the linking module connector apparatus, and a linking apparatus; such that, when the linking module connector apparatus is in engagement with the transformer module connector apparatus, the linking apparatus connects two or more of the sub-winding sections in a series or parallel manner so as to form at least one secondary winding.

In this way, the transformer may be manufactured and configured in a very convenient manner. The transformer module will be the same for many desired transformer arrangements and can therefore be manufactured in bulk, providing for economic and efficient manufacture. A set of linking modules will required with the majority of transformer configurations requiring a small subset of the available set of linking modules. This small subset of linking modules can then also be manufactured in large quantities with the associated advantages of efficiency and cost savings, while the less commonly used linking modules can be manufactured quickly and easily. Furthermore, there are advantages in the sale and supply of the switched mode power supply transformer of the invention, as a supplier can maintain stocks of the transformer module and various linking modules and then assemble a switched mode power supply transformer according to a customer's requirements simply by selecting the required linking modules and connecting them to a transformer module. Thus providing a product that meets the customer's requirements in efficient and timely manner.

In another embodiment of the invention there is provided a transformer in which each discrete sub-winding section comprises a pair of ends, and the transformer module connector apparatus comprises a plurality of terminals wherein each of the ends of the sub-winding sections is connected to one terminal of the transformer module connector apparatus. A multi-terminal connector apparatus is a particularly effective manner of providing connection between the transformer module and the linking module.

In a further embodiment of the invention there is provided a transformer in which the linking module connector apparatus comprises a plurality of terminals and the linking apparatus provides a connection between the transformer output and two of the terminals of the linking module connector apparatus, and a link between one or more pairs of terminals of the linking module connector apparatus such that the associated sub-winding sections are connected in series or in parallel. This is a particularly effective way of providing the necessary connections between the sub-winding sections, and between the sub-winding sections and the outputs.

In an alternative embodiment of the invention there is provided a transformer in which the linking apparatus comprises one or more zero ohm interconnections. Such connections may take the form of PCB tracks, zero-ohm links, zero-ohm resistors, solder links, wire links and the like..

In an embodiment of the invention there is provided a transformer in which the linking apparatus comprises one or more zero ohm interconnections connected between terminals of the linking module connector apparatus. This is a particularly efficient way of providing the required links.

In one embodiment of the invention there is provided a transformer in which the transformer module connector apparatus comprises a multi-terminal female connector and the linking module connector apparatus comprises a multi-terminal male connector. In this way, the live terminals of the connector are not exposed when there is no linking module connected to the transformer module. Additionally, this arrangement provides efficient use of space.

In another embodiment of the invention there is provided a transformer in which the at least one secondary winding is connected to a transformer output. In this way the output of the transformer may be fed to load connected to the transformer output.

In a further embodiment of the invention there is provided a transformer in which, in use, the at least one secondary winding comprises each sub-winding section thereof. In this way, the transformer utilisation is maximised and no sub-winding sections are left unused.

In an alternative embodiment of the invention there is provided a transformer in which, in use, the secondary winding comprises a subset of the sub-winding sections thereof. In this way, there is a large number of options for secondary winding configurations, providing for increased flexibility of the transformer of the invention.

In an embodiment of the invention there is provided a transformer in which each of the sub-winding sections within a secondary winding are identical. Identical sub-winding sections will have the same current rating and the same number of turns. By keeping all the sub-winding sections within a secondary winding the same, this provides for ease of design and manufacture.

In one embodiment of the invention there is provided a transformer in which at least one of the sub-winding sections within the at least one secondary winding is rated differently to another sub-winding section within the secondary winding. In this way, the number of secondary winding configuration options is increased.

In another embodiment of the invention there is provided a transformer in which the transformer comprises at least two secondary windings. In this way, the switched mode power supply transformer can supply provide two transformer outputs.

In a further embodiment of the invention there is provided a transformer in which the composition of each of secondary winding is identical to that of the other secondary windings in the transformer. Such an arrangement allows for ease of design and manufacture of the transformer.

In an alternative embodiment of the invention there is provided a transformer in which each secondary winding is connectable to another secondary winding in a series or parallel manner so as to form a combined secondary winding. In this way, the overall configurability of the transformer is increased.

In an embodiment of the invention there is provided a transformer in which the composition of a secondary winding is different to that of another secondary winding in the transformer. This provides for increased overall configurability of the transformer.

In one embodiment of the invention there is provided a transformer in which the linking module comprises a rectifier circuit. In this way, the AC voltage signal at the output of the transformer is fed to the rectifier circuit which will rectify the signal so that it is suitable for connection to a load.

According to the invention there is further provided a transformer module for use in a switched mode power supply transformer comprising a primary winding; a magnetic core; a transformer module connector apparatus; and a plurality of discrete sub-winding sections suitable for forming at least one secondary winding, wherein each sub-winding section is connected to the transformer module connector apparatus for connection to the linking module connector apparatus of the linking module of the invention.

Such a transformer module can be used to provide is switched mode power supply transformer that is small in size, low in weight, is user configurable and has low power losses by providing at least one configurable secondary winding.

In another embodiment of the invention there is provided a transformer module in which each discrete sub-winding section comprises a pair of ends, and the transformer module connector apparatus comprises a plurality of terminals wherein each of the ends of the sub-winding sections is connected to one terminal of the transformer module connector apparatus.

According to the invention there is further provided a linking module for use in a switched mode power supply transformer having a transformer output comprising a linking module connector apparatus suitable for engagement with the transformer module connector apparatus of the transformer module of the invention; a connection between the transformer output and the linking module connector apparatus, and a linking apparatus such that, when the linking module connector apparatus is in engagement with the transformer module connector apparatus, the linking apparatus connects two or more of the sub-winding sections in a series or parallel manner so as to form at least one secondary winding.

Such a linking module can be used to provide is switched mode power supply transformer that is small in size, low in weight, is user configurable and has low power losses.

In a further embodiment of the invention there is provided a linking module in which the linking module connector apparatus comprises a plurality of terminals and the linking apparatus provides a connection between the transformer output and two of the terminals of the linking module connector apparatus, and a link between one or more pairs of terminals of the linking module connector apparatus such that the associated sub-winding sections are connected in series or in parallel.

According to the invention there is further provided a switched mode power supply comprising the transformer, transformer module or linking module according to the invention.

### DETAILED DESCRIPTION OF THE INVENTION

The invention will now be more clearly understood from the following description of an embodiment thereof given by way of example only with reference to the accompanying drawings in which:-
Fig. 1 is a diagrammatic representation of the transformer according to the invention; and
Fig. 2 is a diagrammatic representation of an alternative embodiment of transformer;
Fig. 3 is a schematic representation of the transformer according to the invention;
Fig. 4 is perspective view of an implementation of the invention, showing the transformer module and a linking module;
Fig. 5 is a top view of the implementation of the invention shown in Fig. 4 with the linking module engaging the transformer module;
Fig. 6 is a side view of the transformer module;
Fig. 7 is a top view of the transformer module;

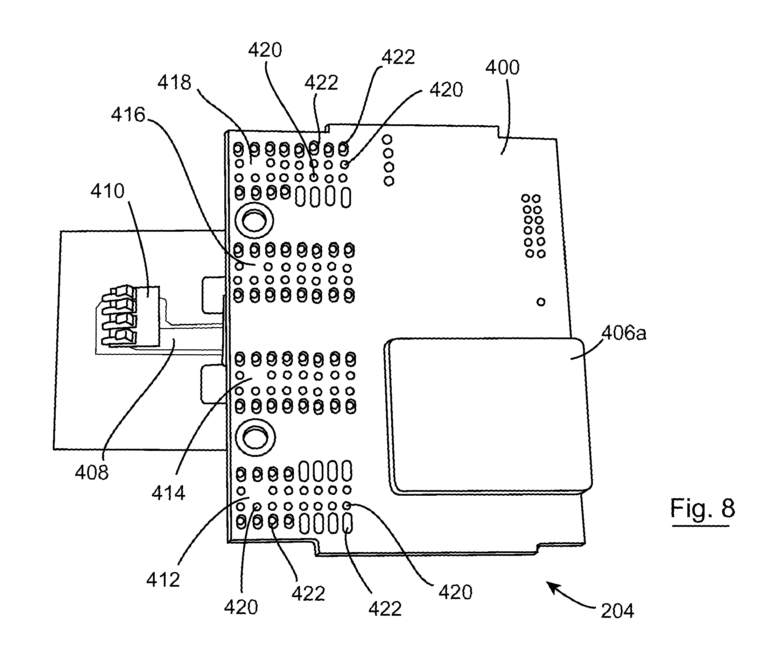

Fig. 8 is a bottom view of the transformer module.

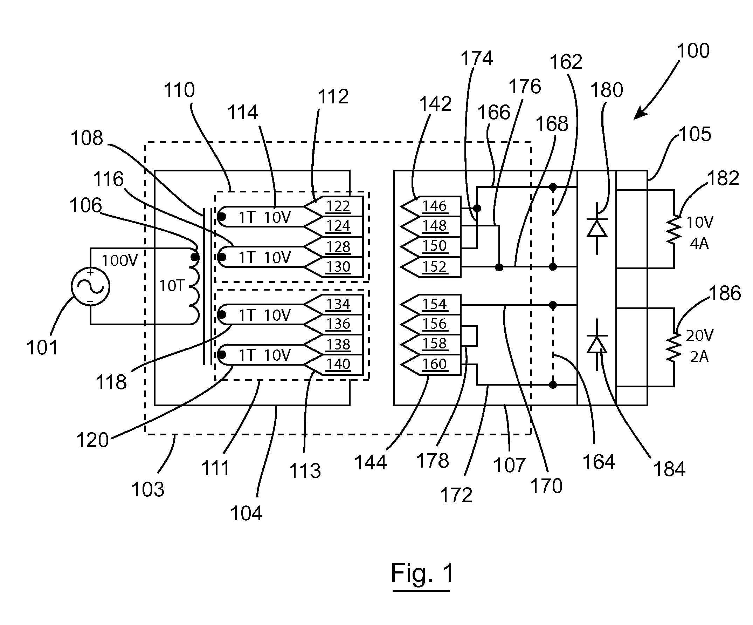

Referring to the drawings, and initially to Fig. 1 thereof, there is shown a switched mode power supply circuit indicated generally by the reference numeral 100 comprising a voltage source 101 supplying a switched mode power supply transformer according to the invention indicated by the dashed box 103. The switched mode power supply transformer 103 comprises a transformer module 104, a first linking module 105 and a second linking module 107. The transformer module 104 comprises a primary winding 106 having ten turns, a toroidal magnetic core 108, a first secondary winding 110, a second secondary winding 111 and a transformer module connector apparatus, in this case comprising a first female connector 112 and a second female connector 113 Each secondary winding 110, 111 is disposed on the magnetic core 108.

The first secondary winding 110 comprises two sub-winding sections, sub-winding section 1 A 114 and sub-winding section 1 B 116, each of one turn. The second secondary winding 111 comprises two sub-winding sections, sub-winding section 2A 118 and sub-winding section 2B 120, each of one turn. Each end of sub-winding section 1 A 114 is connected to one terminal 122, 124 of the first female connector 112 and each end of sub-winding section 1 B 116 is connected to one terminal 128, 130 of the first female connector 112. Each end of sub-winding section 2A 118 is connected to one terminal 134, 136 of the second female connector 113 and each end of sub-winding section 2B 120 is connected to one terminal 138, 140 of the second female connector 132. Each sub-winding section 114, 116, 118, 120 is rated at 2 amps per turn.

The first linking module 105 comprises a linking module connector apparatus in this case comprising a first male connector 142. The first male connector 142 comprises four terminals 146, 148, 150, 152, each disposed to engage a complementary terminal 122, 124, 128, 130 of the first female connector 112 on the transformer module 104. The second linking module 107 comprises a linking module connector apparatus in this case comprising a second male connector 144. The second male connector 144 comprises four terminals 154, 156, 158, 160, each disposed to engage a complementary terminal 134, 136, 138, 140 of the second female connector 113.

The first linking module 105 further comprises a first transformer output 162 corresponding to the output of the first secondary winding 110. There is a pair of connections 166, 168 between the first male connector 142 and the first transformer output 162. The first linking module 105 further comprises a linking apparatus, in this case comprising a pair of interconnections 174, 176 between terminals of the first male connector 142.

The second linking module 107 further comprises a second transformer output 164 corresponding to the output of the second secondary winding 111. There is a pair of connections 170, 172 between the second male connector 144 and the second transformer output 164. The second linking module 107 further comprises a linking apparatus, in this case comprising one interconnection 178 between terminals of the second male connector 144.

The outputs of two terminals 146, 150 of the first male connector 142, corresponding to the first ends of sub-winding section 1 A 114 and sub-winding section 1 B 116 respectively are connected together by the interconnections 174 of the linking apparatus, forming a single output which is connected to the connection 166 which is in turn connected to the first terminal of the first transformer output 162. The outputs of two terminals 148, 152 of the first male connector 142, corresponding to the second ends of sub-winding section 1 A 114 and sub-winding section 1B 116 respectively are connected together by the interconnection 176 of the linking apparatus, forming a single output which is connected to the connection 168 which is in turn connected to the second terminal of the first transformer output 162. Therefore, in use, when all the corresponding terminals of the first female connector 112 and the first male connector 142 are correctly connected, sub-winding section 1 A 114 and sub-winding section 1B 116 are connected in parallel, such that the first secondary winding 110 is a winding of one turn, rated at 4 amps per turn.

The output of terminal 154 of the second male connector 144, corresponding to the first end of sub-winding section 2A 118, is fed, via connection 170, to the first terminal of the second transformer output 164, while the output of terminal 160 of the second male connector 144, corresponding to the second end of sub-winding section 2B 120 is fed, via connection 172 to the second terminal of the second transformer output 164. The outputs of terminal 156, corresponding to the second end of sub-winding section 2A 118, and terminal 158, corresponding to the first end of sub-winding section 2B 120, are connected together by interconnection 178. Therefore, in use, when all the corresponding terminals of the second female connector 113 and the second male connector 144 are correctly connected, sub-winding section 2A 118 and sub-winding section 2B 120 are connected in series, such that the second secondary winding 111 is a winding of two turns, rated at 2 amps per turn, with the second transformer output 164 corresponding to the first end of sub-winding section 2A 118 and the second end of sub-winding section 2B 120.

On the first linking module 105, the first transformer output 162 is connected to a first rectification module 180, which is in turn connected to a first load 182, in this case a 10 volt, 4 amp load. On the second linking module 107, the second transformer output 164 is connected to a second rectification module 184, which is in turn connected to a second load 186, in this case a 20 volt, 2 amp load.

In use, if the voltage source 101 is supplying 100V to the primary winding 106 having 10 turns, and there are two secondary windings 110, 111, the first of one turn and rated at 4 amps per turn and the second of two turns and rated at 2 amps per turn. The first secondary winding 110 will therefore be able to supply the first load 182 with 10V and up to 4 amps of current. The second secondary winding 111 will be able to supply the second load 186 with 20V and up to 2 amps of current.

Therefore, by varying the connections 166, 168, 170, 172 of the linking modules 105, 107 and the interconnections 174, 176, 178 of the linking apparatus of the linking modules 105, 107, each secondary winding of this switched mode power supply transformer 103 can be configured to generate one of the following transformer outputs:
- 10V and up to 4 amps of current (using the connections described above and illustrated in Fig. 1 in relation to the first secondary winding 110)
- 20V and up to 2 amps of current (using the connections described above and illustrated in Fig. 1 in relation to the second secondary winding 111)
- 10V and up to 2 amps of current (using only one of the available sub-winding sections and leaving the second sub-winding section unconnected (not shown))

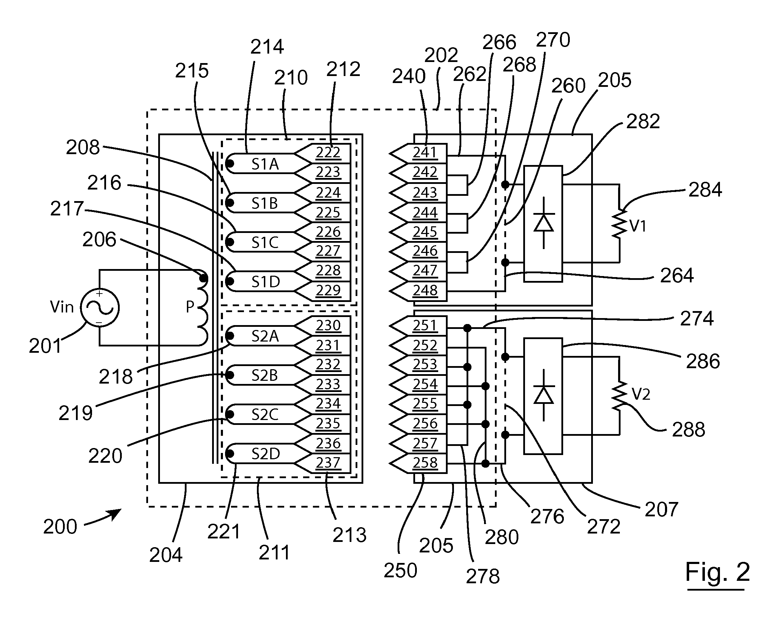

Referring to Fig. 2, there is shown a switched mode power supply circuit indicated generally by the reference numeral 200 comprising a voltage source 201 supplying a switched mode power supply transformer according to the invention indicated by the dashed box 202. The switched mode power supply transformer 202 comprises a transformer module 204, a first linking module 205 and a second linking module 207. The transformer module 204 comprises a primary winding 206, a toroidal magnetic core 208, a first secondary winding 210, a second secondary winding 211 and a transformer module connector apparatus, in this case comprising a first female connector 212 and a second female connector 213. Each secondary winding 210, 211 is disposed on the magnetic core 208.

The first secondary winding 210 comprises four sub-winding sections sub-winding section S1A 214, sub-winding section S1B 215, sub-winding section S1C 216 and sub-winding section S1D 217. The second secondary winding 211 comprises four sub-winding sections sub-winding section S2A 218, sub-winding section S2B 219, sub-winding section S2C 220 and sub-winding section S2D 221.

Each end of sub-winding section S1A 214 is connected to one terminal 222, 223 of the first female connector 212; each end of sub-winding section S1B 215 is connected to one terminal 224, 225 of the first female connector 212; each end of sub-winding section S1C 216 is connected to one terminal 226, 227 of the first female connector 212; and each end of sub-winding section S1 D 217 is connected to one terminal 228, 229 of the first female connector 212.

Each end of sub-winding section S2A 218 is connected to one terminal 230, 231 of the second female connector 213; each end of sub-winding section S2B 219 is connected to one terminal 232, 233 of the second female connector 213; each end of sub-winding section S2C 220 is connected to one terminal 234, 235 of the second female connector 213; and each end of sub-winding section S2D 221 is connected to one terminal 236, 237 of the second female connector 213.

The first linking module 205 comprises a linking module connector apparatus in this case comprising a first male connector 240. The first male connector 240 comprises eight terminals 241, 242, 243, 244, 245, 246, 247, 248, each disposed to engage a complementary terminal 222, 223, 224, 225, 226, 227, 228, 229, of the first female connector 212 on the transformer module 204. The second linking module 207 comprises a linking module connector apparatus in this case comprising a second male connector 250. The second male connector 250 comprises eight terminals 251, 252, 253, 254, 255, 256, 257, 258, each disposed to engage a complementary terminal 230, 231, 232, 233, 234, 235, 236, 237 of the second female connector 213.

The first linking module 205 further comprises a first transformer output 260 corresponding to the output of the first secondary winding 210. There is a pair of connections 262, 264 between the first male connector 240 and the first transformer output 260. The first linking module 205 further comprises a linking apparatus, in this case comprising a plurality of interconnections 266, 268, 270 between terminals of the first male connector 240.

The second linking module 207 further comprises a second transformer output 272 corresponding to the output of the second secondary winding 211. There is a pair of connections 274, 276 between the second male connector 250 and the second transformer output 272. The second linking module 207 further comprises a linking apparatus, in this case comprising a pair of interconnections 278, 280 between terminals of the two sets of four terminals of the second male connector 250.

The output of terminal 241 of the first male connector 240, corresponding to the first end of sub-winding section S1A 214, is fed, via connection 262, to the first terminal of the first transformer output 260, while the output of terminal 248 of the first male connector 240, corresponding to the second end of sub-winding section S1 D 217 is fed, via connection 264 to the second terminal of the first transformer output 260. The outputs of terminal 242, corresponding to the second end of sub-winding section S1A 214, and terminal 243, corresponding to the first end of sub-winding section S1B 215, are connected together by interconnection 266. The outputs of terminal 244, corresponding to the second end of sub-winding section S1 B 215, and terminal 245, corresponding to the first end of sub-winding section S1C 216, are connected together by interconnection 268. The outputs of terminal 246, corresponding to the second end of sub-winding section S1C 216, and terminal 247, corresponding to the first end of sub-winding section S1D 217, are connected together by interconnection 270. Therefore, in use, when all the corresponding terminals of the first female connector 212 and the first male connector 240 are correctly connected, sub-winding section S1A 214, sub-winding section S1B 215, sub-winding section S1C 216 and sub-winding section S1D 217 are connected in series, thus providing a total number of turns in the first primary winding equal to the sum of the turns in each sub-winding section, with the first transformer output 260 corresponding to the first end of sub-winding section S1A 214 and the second end of sub-winding section S1 D 217.

The outputs of four terminals 251, 253, 255, 257 of the second male connector 250, corresponding to the first ends of sub-winding sections S2A 218, sub-winding section S2B 219, sub-winding section S2C 220, and sub-winding section S2D 221 respectively are connected together by the interconnections 278 of the linking apparatus, forming a single output which is connected to the connection 274 which is in turn connected to the first terminal of the second transformer output 272. The outputs of four terminals 252, 254, 256, 258 of the second male connector 250, corresponding to the second ends of sub-winding sections S2A 218, sub-winding section S2B 219, sub-winding section S2C 220, and sub-winding section S2D 221 respectively are connected together by the interconnections 280 of the linking apparatus, forming a single output which is connected to the connection 276 which is in turn connected to the second terminal of the second transformer output 272. Therefore, in use, when all the corresponding terminals of the second female connector 213 and the second male connector 250 are correctly connected, sub-winding sections S2A 218, sub-winding section S2B 219, sub-winding section S2C 220, and sub-winding section S2D 221 are connected in parallel, thereby providing with the second secondary winding 211 with a current rating equal to the sum of the current ratings of the sub-winding sections thereof.

On the first linking module 205, the first transformer output 260 is connected to a first rectification module 282, which is in turn connected to a first load 284. On the second linking module 207, the second transformer output 272 is connected to a second rectification module 286, which is in turn connected to a second load 288.

Therefore, by varying the connections 262, 264, 274, 276 of the linking modules 205, 207 and the interconnections 262, 264, 266, 278, 280 of the linking apparatus of the linking modules 205, 207, each secondary winding of this switched mode power supply transformer 202 can be configured to generate one of the following transformer outputs:
The output of each terminal of the male connectors 240, 250 of the secondary windings 210, 211 may be connected to one or more of the outputs of the other terminals of that male connector so that some or all of the sub-winding sections of that secondary winding are be connected in series or in parallel. It is not necessary that each sub-winding section within the secondary winding be used. It is possible to connect two or more sub-windings in parallel and then connect that sub-winding combination in series with another sub-winding or sub-winding combination and vice versa. Overall, the embodiment of transformer shown in Fig. 2 is capable of implementing three different voltage and current combinations that fully utilise the transformer windings and a greater number of under-utilised combinations are also possible.

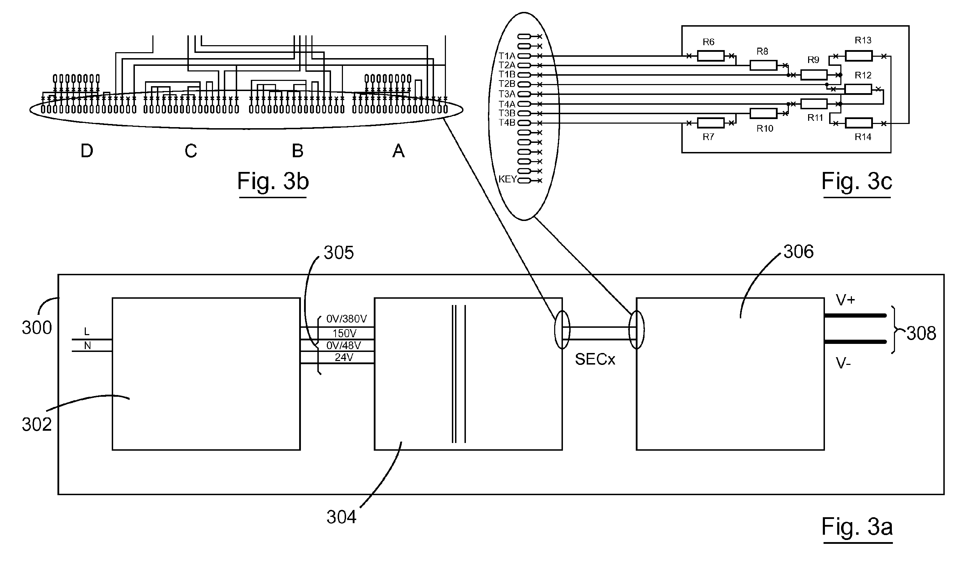

Referring now to Fig. 3a, in which like parts have been given the same reference numerals as before, there is shown a circuit schematic of a system 300 comprising the transformer 202 of the invention. The system 300 comprises an input stage board 302, which supplies power to the primary winding of the transformer which is implemented on the winding board PCB 304. The input stage board 302 implements Power Factor Correction and is connected to the winding board by a power bus 305. The winding board 304 further comprises the sub-winding sections that form the secondary windings of the transformer. The winding board corresponds to the transformer module 204 of Fig. 2. The winding board is then connected to a final output stage board 306, wherein the linking apparatus is implemented. The output stage board corresponds to a linking module 205, 207 of Fig. 2. The final output will be supplied to a load connected across terminals 308. There will be an output stage board 306 for each output required from the transformer. For example, if the transformer is required to provide a 5V, 3V3 and 2V5 supply, then the transformer will require three output stage boards.

Fig. 3b is a circuit schematic of the transformer module connector apparatus associated with each of the sub-winding sections of the winding board 304. There are four female connectors marked A, B, C and D, each corresponding to a single secondary winding. Each secondary winding comprises four sub-winding sections. Each connector has one terminal connected to one end of each of the four sub-winding sections of an individual secondary winding, such that each end of each sub-winding section is connected to a terminal. Each connecter will engage with a linking module connector apparatus, in this case a male connector mounted on an output stage board, as illustrated in Fig. 3c.

Fig. 3c is a circuit schematic of one linking module connector apparatus, in this case a male connector mounted on the output stage board 306 which is connected to one secondary winding on the winding board 304. The connector comprises eight inputs, T1A, T2A, T1B, T2B, T3A, T3B, T4A, T4B which are adjacent each other in that order. Interconnection R6 is connected between T1A and T2A; interconnection R7 is connected between T3B and T4B; interconnection R8 is connected between T2A and T1B; interconnectionR9 is connected between T1B and T2B; interconnection R10 is connected between T3B and T4A; interconnection R11 is connected between T3A and T4A; interconnection R12 is connected between T2B and T3A; interconnection R13 is connected between T2B and T4B; and interconnection R14 is connected between T3A and T1A. The interconnections R6 to R14 may be fitted with zero ohm links or left unused so that by fitting certain zero ohm link combinations, the sub-winding sections can be connected in series, parallel or a series/parallel combination, as required.

### Example A

Each of R6, R9, R11, R7, R13, R14 fitted with a zero-ohm link results in four, single-turn windings connected in parallel, as all four sub-windings are connected in parallel.

### Example B

Each of R8, R12, R10 fitted with a zero-ohm link results in a single, four-turn winding as all sub-winding sections are connected in series.

### Example C

Each of R6 and R9 fitted with zero-ohm links results in two sub-windings connected in parallel;
Each of R11 and R7 fitted with zero-ohm links results in two sub-windings connected in parallel; and
R12 fitted with a zero-ohm link results in the two paralleled sections above being connected in series
This combination of resistors gives two, two-turn windings connected in parallel.

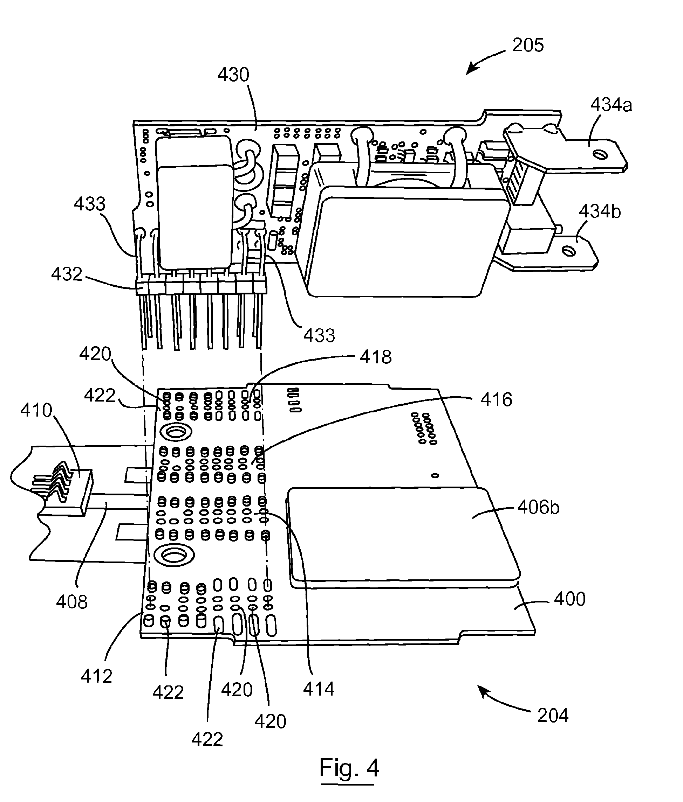

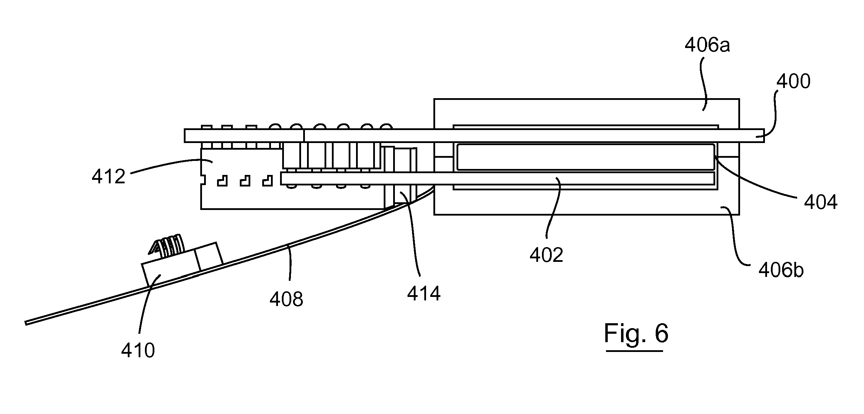

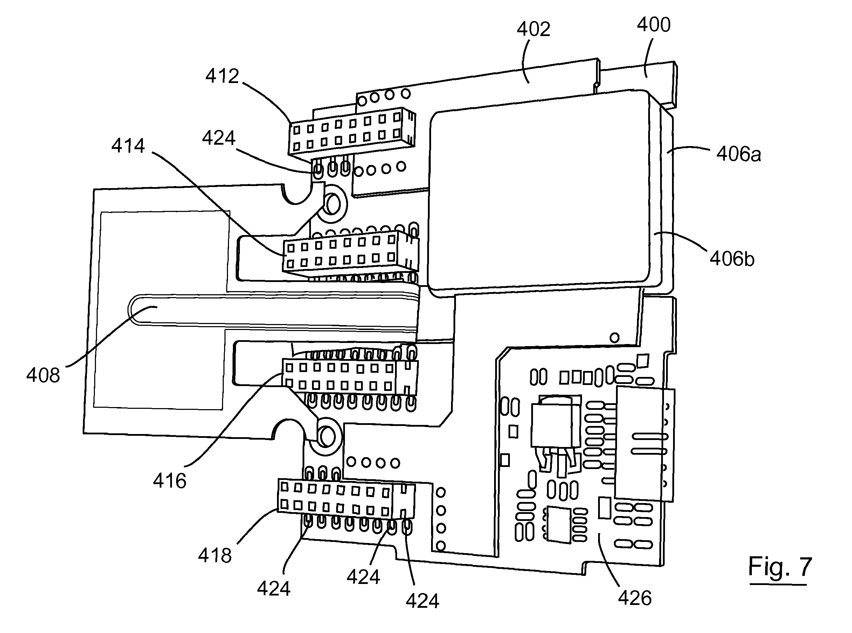

Referring now to Figs 4 to 7, there is shown an implementation of the switched mode power supply transformer of the invention suitable for providing four outputs. The switched mode power supply transformer comprises a transformer module indicated generally by the reference numeral 204 and a linking module indicated generally by the reference numeral 205. The transformer module 204 comprises three multilayer PCBs, an upper secondary winding board 400 which is substantially rectangular in shape; a lower secondary board 402; and a primary board 404. The upper secondary winding board 400 implements the discrete sub-winding sections of two secondary windings while the lower secondary board 402 implements the discrete sub-winding sections of another two secondary windings. Each discrete sub-winding comprises one turn. The primary board 404 implements the primary winding of the transformer, wherein the primary winding comprises sixteen turns. Each of the boards 400, 402, 404 is implemented according to standard PCB layout practice.

The transformer module 204 further comprises an ER type ferromagnetic core comprising two halves, 406a, 406b each substantially E-shaped in cross section. The core 406a, 406b is located towards the lower right-hand corner of the upper secondary winding board 400, adjacent its first longitudinal side.

A power bus 408 connects to the transformer module 204. The power bus 408 terminates in a four terminal power connector 410 for connection to an input stage board (not shown) corresponding to the input stage board 302 of Fig. 3a. The power bus 408 corresponds to the power bus 305 shown in Fig. 3a and supplies the transformer module 204 with +190V to -190V square wave voltage.

Disposed adjacent the second longitudinal side of the upper secondary winding board 400 are four transformer module connector apparatus 412, 414, 416, 418, in this case female connectors comprising sixteen terminals, arranged as two parallel rows of eight terminals, of which only 15 terminals are implemented on the upper secondary winding PCB 400. The transformer module connector apparatus 412, 414, 416, 418 are mounted on the underside of the upper secondary winding PCB 400 such that the top surface of the board 400 comprises only openings 420 corresponding to each of the terminals. Adjacent each opening 420 is a mounting point 422 for a mounting pin 424 of the connector. The underside of the upper secondary winding board further mounts some standard components, indicated generally by the reference numeral 426 for implementation of the transformer of the intention.

The transformer module connector apparatus 412, 418 at either end of the upper secondary winding board 400 are connected to the two secondary windings of the lower secondary winding board 402, while the middle two transformer module connector apparatus 414, 416 are connected to the two secondary windings of the upper secondary winding board 400. The connection between the discrete sub-windings on the lower secondary board 402 and the transformer module connector apparatus 412, 418 of the upper secondary winding board 400 is accomplished using a plurality of pins 428 bridging the two boards 400, 402. Each secondary winding of the lower secondary board 402 uses eight pins 428 to connect to the relevant transformer module connector apparatus on the upper secondary winding board 400, such that each pin 428 is connected to one end of one discrete sub-winding section.

The linking module 205 comprises a single multilayer linking module PCB 430 mounting a linking module connector apparatus 432 comprising a 15 terminal male connector, which is complementary to the female connectors of the transformer module connector apparatus 412, 414, 416, 418 of the transformer module 204. The linking module connector apparatus 432 has cranked terminals 433 so as to allow the linking module PCB 430 to project vertically from the topside of the upper secondary winding PCB 400, when the linking module connector apparatus 432 is brought into engagement with one of transformer module connector apparatus 412, 414, 416, 418. The linking module PCB 430 provides a linking apparatus comprising interconnections, in the form of PCB tracks (not shown), between the terminals 433 of the linking module connector apparatus 432, allowing the sub-winding sections of the secondary winding to be connected in series or in parallel. Additionally, the linking module PCB 430 comprises connections, in the form of PCB tracks (not shown) between terminals of the linking module connector apparatus and the transformer output. The linking module PCB 430 further comprises components forming a rectifier module, corresponding to rectifier modules 180, 184, 282, 286 shown in Figs 1 and 2, for rectification of the signal at the transformer output. The final output of the transformer of the invention is taken across the output terminals 434a, 434b.

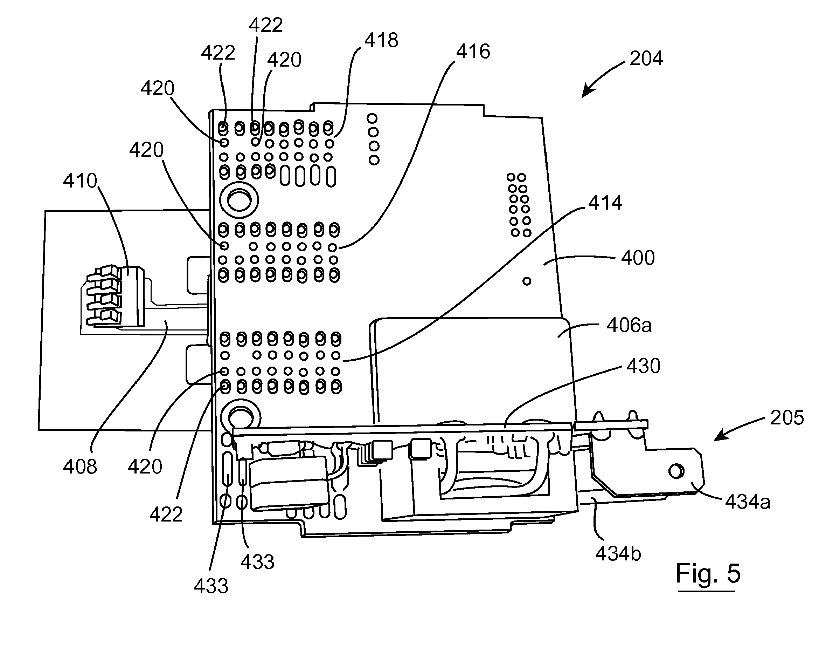

In use, the transformer module 204 is connected via the power bus 408 and power connector 410 to an input stage board and one or more linking modules 205 are connected to the transformer module 204 by bringing the linking module connector apparatus 432 into engagement with one of the transformer module connector apparatus 412, 414, 416, 418 such that the linking apparatus of the linking module that connects terminals of the linking module connector apparatus 432 forms interconnections between the sub-winding sections of the secondary winding connected to that transformer module connector apparatus 412, 414, 416, 418. Fig. 4 shows a linking module 205 about to be brought into engagement with transformer module connector apparatus 412 of the transformer module 204, while Fig. 5 shows a top view of the linking module 205 connected to the transformer module 204.

While the transformer module linking apparatus and linking module apparatus have been described in the specification as each comprising a single connector comprising multiple terminals, it will be understood that each term also encompasses a collection of smaller connecters or similar arrangements.

Throughout the specification, the term discreet sub-winding section will be understood to refer to a portion of a transformer winding that not is electrically connected to other portions of the transformer winding.

It will be understood by the person skilled in the art that the invention is not limited to this manner of connection of the sub-winding sections and that other methods may be applied. It will be further understood the above-described manner of connection, using separate connection means to those used for connecting the sub-winding sections, may also be used to connect secondary windings if desired.

Throughout the specification, references made to the composition of a secondary winding will be understood to refer to the set of sub-winding sections that are available within that secondary winding for interconnection in series or in parallel. Furthermore, references made to the configuration of a secondary winding will be understood to refer to the set of sub-winding sections that have been interconnected within that secondary winding and the manner of their interconnection.

Throughout the specification, the term identical, when referring to sub-winding sections, means that the sub-winding sections in question have the same current rating and the same number of turns.

Throughout the specification, references to a user configurable transformer will be understood to refer to a transformer that may be configured by a person unskilled in transformer technology and that may be configured in any location and without the requirement of special equipment.

In the specification the terms 'comprise', 'comprises', 'comprised' and 'comprising' or any variation thereof and the terms 'include', 'includes', 'included' or 'including' or any variation thereof are considered to be totally interchangeable and they should all be afforded the widest possible interpretation.

The invention is not limited to the embodiment herein described, but may be varied in both construction and detail within the terms of the claims.

## Claims

1. A switched mode power supply transformer for use in a modular switched mode power supply, the transformer comprising a primary winding, a magnetic core and at least one secondary winding **characterised in that** the at least one secondary winding comprises at least one of a plurality of discrete sub-winding sections, each sub-winding section being connectable to another sub-winding section in the at least one secondary winding in a series or parallel manner.

2. A transformer as claimed in claim 1, in which the transformer comprises a transformer module, a linking module and at least one transformer output, wherein
the transformer module comprises
a transformer module connector apparatus;
and the plurality of discrete sub-winding sections, each of which is connected to the transformer module connector apparatus;
and the linking module comprises
a linking module connector apparatus suitable for engagement with the transformer module connector apparatus;
a connection between the transformer output and the linking module connector apparatus, and
a linking apparatus;
such that, when the linking module connector apparatus is in engagement with the transformer module connector apparatus, the linking apparatus connects two or more of the sub-winding sections in a series or parallel manner so as to form at least one secondary winding.

3. A transformer as claimed in claim 2 in which each discrete sub-winding section comprises a pair of ends, and the transformer module connector apparatus comprises a plurality of terminals wherein each of the ends of the sub-winding sections is connected to one terminal of the transformer module connector apparatus.

4. A transformer as claimed in claim 2 or 3 in which the linking module connector apparatus comprises a plurality of terminals and the linking apparatus provides
a connection between the transformer output and two of the terminals of the linking module connector apparatus, and
a link between one or more pairs of terminals of the linking module connector apparatus such that the associated sub-winding sections are connected in series or in parallel.

5. A transformer as claimed in any of claims 2 to 4 inclusive in which the linking apparatus comprises one or more zero ohm interconnections.

6. A transformer as claimed in claim 4 or 5 in which the linking apparatus comprises one or more zero ohm interconnections connected between terminals of the linking module connector apparatus.

7. A transformer as claimed in any preceding claim in which the transformer module connector apparatus comprises a multi-terminal female connector and the linking module connector apparatus comprises a multi-terminal male connector.

8. A transformer as claimed any preceding claim in which the at least one secondary winding is connected to a transformer output.

9. A transformer as claimed in any preceding claim which, in use, the at least one secondary winding comprises each sub-winding section thereof.

10. A transformer as claimed in any of claims 1 to 8 in which, in use, the secondary winding comprises a subset of the sub-winding sections thereof.

11. A transformer as claimed in any preceding claim in which each of the sub-winding sections within a secondary winding are identical.

12. A transformer as claimed in any preceding claim in which at least one of the sub-winding sections within the at least one secondary winding is rated differently to another sub-winding section within the secondary winding.

13. A transformer as claimed in any preceding claim in which the transformer comprises at least two secondary windings.

14. A transformer as claimed claim 13 in which the composition of each of secondary winding is identical to that of the other secondary windings in the transformer.

15. A transformer as claimed in claim 13 or 14 in which each secondary winding is connectable to another secondary winding in a series or parallel manner so as to form a combined secondary winding.

16. A transformer as claimed in any of claims 13 to 15 inclusive in which the composition of a secondary winding is different to that of another secondary winding in the transformer.

17. A transformer as claimed in any preceding claim in which the linking module comprises a rectifier circuit.

18. A transformer module for use in a switched mode power supply transformer comprising
a transformer module connector apparatus; and
a plurality of discrete sub-winding sections suitable for forming at least one secondary winding,
wherein each sub-winding section is connected to the transformer module connector apparatus for connection to the linking module connector apparatus of the linking module of claim 20.

19. A transformer module as claimed in claim 18 in which each discrete sub-winding section comprises a pair of ends, and the transformer module connector apparatus comprises a plurality of terminals wherein each of the ends of the sub-winding sections is connected to one terminal of the transformer module connector apparatus.

20. A linking module for use in a switched mode power supply transformer having a transformer output comprising
a linking module connector apparatus suitable for engagement with the transformer module connector apparatus of the transformer module of claim 18 or 19;
a connection between the transformer output and the linking module connector apparatus, and
a linking apparatus
such that, when the linking module connector apparatus is in engagement with the transformer module connector apparatus, the linking apparatus connects two or more of the sub-winding sections in a series or parallel manner so as to form at least one secondary winding.

21. A linking module as claimed in claim 20 in which the linking module connector apparatus comprises a plurality of terminals and the linking apparatus provides
a connection between the transformer output and two of the terminals of the linking module connector apparatus, and
a link between one or more pairs of terminals of the linking module connector apparatus such that the associated sub-winding sections are connected in series or in parallel.

22. A switched mode power supply comprising the transformer, transformer module or linking module of any preceding claim.
